(19) Europäisches Patentamt

European Patent Office

Office européen des brevets

(11) Veröffentlichungsnummer: **0 302 237 B1**

# (12) EUROPÄISCHE PATENTSCHRIFT

(45) Veröffentlichungstag der Patentschrift: **22.01.92**

(21) Anmeldenummer: **88110592.8**

(22) Anmeldetag: **02.07.88**

(51) Int. Cl.⁵: **H05K 7/20**, H01L 23/473

(54) Schaltungsanordnung mit mehreren zu kühlenden elektrischen Elementen.

(30) Priorität: **03.08.87 CH 2975/87**

(43) Veröffentlichungstag der Anmeldung:
**08.02.89 Patentblatt 89/06**

(45) Bekanntmachung des Hinweises auf die
Patenterteilung:
**22.01.92 Patentblatt 92/04**

(84) Benannte Vertragsstaaten:
**DE ES FR GB IT SE**

(56) Entgegenhaltungen:
**BE-A- 2 740 630**
**CH-A- 471 488**

(73) Patentinhaber: **H.A. SCHLATTER AG**
**Brandstrasse 24**
**CH-8952 Schlieren Zürich(CH)**

(72) Erfinder: **Denzler, Emil**
**Ländliweg 21**
**CH-8116 Würenlos(CH)**

(74) Vertreter: **Keller, René, Dr. et al**
**Patentanwälte Dr. René Keller & Partner**
**Postfach 12**
**CH-3000 Bern 7(CH)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft eine Schaltungsanordnung gemäss dem Oberbegriff des Patentanspruchs 1.

Eine Anordnung dieser Art ist aus der CH-A 471 488 bekannt. Die als Gleichrichteranlage mit einem Transformator ausgebildete Schaltungsanordnung hat eine stromführende Schiene, auf der Halbleiterscheibenzellen mit einer ihrer Elektroden anliegen. Die Kühlung der Halbleiterscheibenzellen erfolgt durch die Schiene, die mehrere Kühlkanäle aufweist, wobei benachbarte Kühlkanäle vom Kühlmittel in entgegengesetzter Richtung durchströmt werden.

Eine andere Anordnung dieser Art ist aus der DE-A 27 40 630 bekannt. Es handelt sich um eine Hochstrom-Gleichrichteranordnung, bei der die Kontaktflächen des Halbleiter-Gleichrichterelements zwischen mit Kühlkanälen versehenen Anschlussleitern festgeklemmt sind. Die Kühlkanäle sind durch Kühlmittelleitungen an einen Kühlmittelkreislauf angeschlossen.

Es wird die Aufgabe gelöst, die Schaltungsanordnung in kompakter, auch bei niederohmigen Hochstromkreisen elektrodynamisch stabiler Bauweise so aufzubauen, dass eine optimale, gleichmässige Kühlung der elektrischen Elemente gewährleistet und nur je ein Anschluss für den Kühlmittelzu- und -rückfluss ohne zusätzliche Kühlmittelleitungen und Fittings erforderlich ist.

Die durch die Erfindung erzielten Vorteile sind im wesentlichen darin zu sehen, dass durch die Ausbildung der elektrischen Leiter als Kühlmittelkreislauf zusätzliche Installationen für das Kühlmittel entfallen, und durch die Parallelkühlung sämtliche Elemente annähernd auf die gleiche Temperatur gekühlt werden, so dass der wärmebedingte elektrische Wirkungsgrad der Elemente gleich hoch bleibt.

Vorzugsweise ist der Kühlmittelverteiler in einem als elektrischen Leiter dienenden Mittelbalken zentral für Zu- und Rückfluss zu den Elementen ausgebildet und die elektrischen Elemente sowie deren Anschlussleiter in kompakter, einfach zu montierender und mechanisch stabiler Bauweise sandwichartig an je zwei Seiten des den gemeinsamen Kühlmittelverteiler bildenden Mittelbalkens angebaut.

Im folgenden wird ein Ausführungsbeispiel anhand der Zeichnung näher erläutert. Es zeigen:

Fig. 1    ein elektrisches Schaltschema einer Schaltungsanordnung eines Dreiphasentransformators mit Halbleiterdioden,

Fig. 2    eine perspektivischen Darstellung eines Teils der Schaltungsanordnung nach Fig. 1,

Fig. 3    eine Seitenansicht auf die Andruckplatten der Schaltungsanordnung,

Fig. 4    einen Schnitt in der strichpunktiert in Fig. 2 angedeuteten Schnittebene in Blickrichtung des Pfeiles IV.

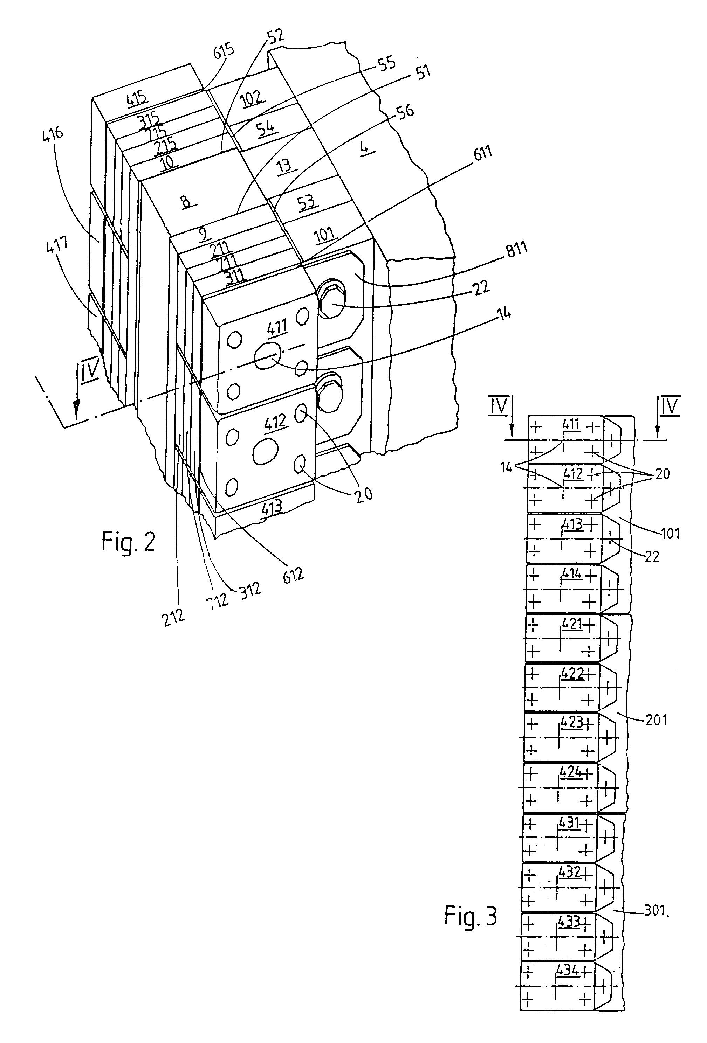

Die Schaltungsanordnung besteht aus einem Dreiphasenhochstromtransformator 4 mit den Primärwicklungen 5, 6, 7 und den Sekundärwicklungen 1, 2, 3. Die Sekundärwicklungen 1, 2, 3 sind endseitig an Kupferbalken 101/102, 201/202, sowie 301/302 und mit je einer Mittelanzapfung an einen Mittelanzapfungsbalken 13 (aus Kupfer) angeschlossen (Fig. 1, 2, 3). An diesen ist mittels (nicht dargestellter) Schrauben ein Mittelbalken 8 angepresst, so dass die Balken 8 und 13 elektrisch leitend und mechanisch stabil verbunden sind. Die Balken 101, 201, 301 sind miteinander fluchtend in einer zum Balken 13 parallelen Reihe an dessen in Fig.2 rechter Seite angeordnet und durch eine Isolierplatte 53 von ihm isoliert und distanziert (Fig. 2 und 3). Die Balken 102, 202, 302 sind entsprechend in einer Reihe an der linken Seite des Balkens 13 angeordnet und durch eine Isolierplatte 54 von ihm getrennt. Die Balken 13, 101, 102, 201, 202, 301, 302 und die Isolierplatten 53, 54 bilden so ein an der Vorderseite des Transformators 4 angeordnetes Paket. Zwischen der dem Transformator 4 abgewandten Fläche der Balkenreihe 101, 201, 301 bzw 102, 202, 302 und weiteren, im folgenden zu beschreibenden Teilen der Schaltungsanordnung ist eine Isolationsfolie 55 bzw. 56 angeordnet.

Die Gleichrichtung erfolgt durch je vier Halbleiterdioden pro Phasenhalbwelle. Die Polarität der Ausgangsspannung an den durch längliche Platten 9, 10 gebildeten Ausgangsleitern der Dioden ist positiv, kann aber wahlweise durch Montage aller Dioden mit vertauschter Polarität in ihren Halterungen auf negativ geändert werden.

Die insgesamt vierundzwanzig Dioden sind in zwei Reihen zu je zwölf Dioden beidseits des Mittelbalkens 8 angeordnet und durch mit der Ziffer 1 beginnende, dreistellige Bezugszahlen bezeichnet. Die zweiten Ziffern .1. bis .3. kennzeichnen die Phase, die dritten Ziffern sind eine fortlaufende Numerierung von ..1 bis ..4 für die Dioden rechts des Mittelbalkens 8, und ..5 bis ..8 für diejenigen auf der linken Seite.

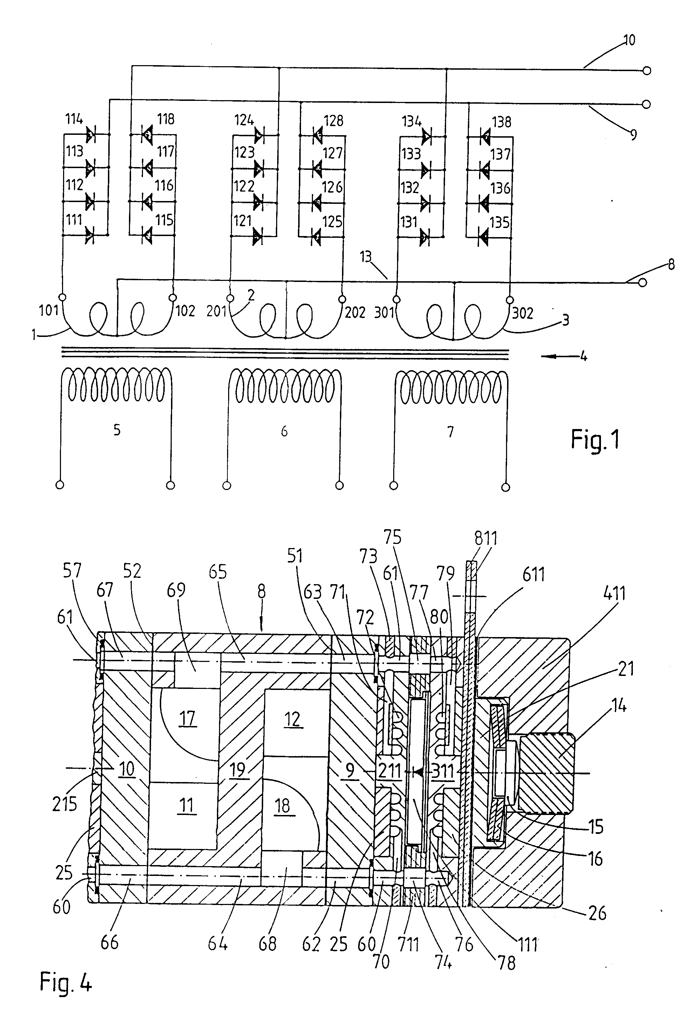

Die Abführung der Verlustwärme der Dioden 111 bis 138 erfolgt über in den elektrischen Leitern fliessendes Kühlwasser. Der rechteckig ausgebildete Mittelbalken 8 hat an seiner unteren Stirnfläche je einen Anschluss 17, 18 für zu- und rückfliessendes Kühlwasser, die direkt in Hohlräumen 11, 12 in seinem Inneren münden. Die Hohlräume 11, 12 sind einander gegenüberliegend als U-förmige Ausfräsungen ausgeführt, wobei der Hohlraum 11 in Fig.4 nach links und der Hohlraum 12 nach rechts offen ist, und die beiden Hohlräume durch einen Steg 19 voneinander getrennt sind, dessen Breite gross genug ist, um Durchgangslöcher für Schrauben (nicht dargestellt) zur Befestigung des Mittelbalkens 8 an der Mittelanzapfung 13 aufzunehmen. Das Kühlwasser wird im Hohlraum 11 von der Platte 10 mittels einer zwischen dem Mittelbalken 8 und der Platte 10 liegenden Dichtungs- und Isolationsfolie 52, und analog der Hohlraum 12 von der Platte 9 mittels einer Dichtungs- und Isolationsfolie 51 abgedichtet. Da der Mittelbalken 8 gegenüber den beiden Platten 9 und 10 unterschiedliches Potential besitzt, sorgen die Dichtungs- und Isolationsfolien 51, 52 neben der Flüssigkeitsabdichtung für elektrische Isolation.

Die Platte 9 mit der Folie 51 und die Platte 10 mit der Folie 52 sind zusammen mit je eine Diode enthaltenden schichtweise aufgebauten Baugruppen durch je vier Schrauben 20 für jede Baugruppe beidseits des Mittelbalkens 8 an diesen angeschraubt. Jede Baugruppe besteht von innen nach aussen aus einer an die Platte 9 bzw. 10 angrenzenden inneren Anschlussleiterplatte, der Diode mit elastischer Zwischenplatte, einer äusseren Anschlussleiterplatte, einem Anschlusslaschenpaar, einer äusseren Isolationsfolie und einer Andruckplatte.

Die an den Elektroden (Kathode und Anode) der Diode anliegenden Anschlussleiterplatten werden im folgenden Elektrodenplatten genannt.

Die Bezeichnung der beiden Elektrodenplatten, des elastischen Zwischenmaterials, der beiden Anschlusslaschen, der äusseren Isolationsfolie und der Andruckplatte erfolgt analog derjenigen der Dioden mit dreistelligen Bezugszahlen, indem die innere Elektrodenplatte zwischen Diode und Platte 9 bzw. 10 eine Zahl beginnend mit der Ziffer 2.., die folgende elastische Zwischenplatte mit 7.., die äussere Elektrodenplatte mit 3.., das Anschlusslaschenpaar mit 8.., die äussere Isolationsfolie mit 6.. und die Andruckplatte mit 4.. erhalten. Die aus der inneren Elektrodenplatte 211, der äusseren Elektrodenplatte 311, der elastischen Zwischenplatte 711, dem Anschlusslaschenpaar 811, der äusseren Isolationsfolie 611, der Andruckplatte 411 und der Diode 111 gebildete Baugruppe ist mit der Platte 9 und der Dichtungs- und Isolierfolie 51 durch die vier Schrauben 20 am Mittelbalken 8 mit der Andruckplatte 411 als Gegenplatte befestigt. Zum Einstellen der für eine gute elektrische Kontaktierung der Diode 111 notwendigen Anpresskraft besitzt die Andruckplatte 411 eine Andruckschraube 14 mit Zylinderknopf 15, eine Anpressfeder 16 und eine Andruckrondelle 21. Entsprechend sind die übrigen die Dioden 112 - 114, 121 - 124 und 131 - 134 enthaltenden Baugruppen mit der Platte 9 und der Folie 51 und die die Dioden 115 - 118, 125 - 128 und 135 - 138 enthaltenden Baugruppen mit der Platte 10 und der Folie 52 an der rechten bzw. linken Seite des Mittelbalkens 8 befestigt.

Die Schrauben 20 sind leitend und in isolierenden Hülsen gefasst, so dass die Andruckplatten 411 - 438 auf gleichem elektrischen Potential wie der Mittelbalken 8 liegen und die dazwischen liegenden Teile von der Platten 411 - 438 und dem Balken 8 isoliert sind. Auf gleichem Potential liegen die Platte 9 bzw. 10 und die inneren Elektrodenplatten 211, 212, .., die durch die Isolationsfolie 51 und die Zwischenplatte 711, 712, ... vom Mittelbalken 8 und den äusseren Elektrodenplatten 311, 312, ..., isoliert sind. Potentialgleich sind die äusseren Elektrodenplatten 311, 312, ... mit den Anschlusslaschenpaaren 811, 812, ..., die durch die Isolationsfolien 611, 612, ... von der Andruckplatte 411, 412, ... und durch die Zwischenplatte 711, 712, ... von der inneren Elektrodenplatte 211, 212, ... isoliert sind.

Die Dioden 111 bis 114, 121 bis 124 und 131 bis 134 liegen flächig unmittelbar an den betreffenden inneren Elektrodenplatten 211 bis 214, 221 bis 224, und 231 bis 234 und diese wiederum an der Platte 9 an; die restlichen Dioden 115 bis 118, 125 bis 128 und 135 bis 138 liegen analog an den Platten 215, 216, ... und diese an der Platte 10 an. Beide Platten 9 und 10 liegen auf gleichem elektrischen Potential und sind nur aufgrund der mechanischen Konstruktion voneinander getrennt.

Der elektrische Anschluss der Diodenanoden an die mit den Sekundärwicklungen 1, 2, 3 des Transformators 4 verbundenen Balken 101, 102, 201, 202, 301, 302 erfolgt über das Anschlusslaschenpaar 811, 812, ... und die äusseren Elektrodenplatten 311, 312, ..... Das Anschlusslaschenpaar 811, 812, ... ist mit Schrauben 22 an den Balken 101, 102, ... befestigt. Pro Balken bzw. Sekundärwicklungsende 101, 102, 201, 202, 301, 302 sind 4 Diodenanoden angeschlossen. So sind z.B. am Balken 101 der Wicklung der ersten Phase 1 die Anoden der Dioden 111, 112, 113, 114, über das Anschlusslaschenpaar 811, 812, ... und die äusseren Elektrodenplatten 311, 312, ... angeschlossen.

Die Breite der Platten 9 und 10 ist geringfügig um einige Millimeter grösser als die Breite der anschliessenden Fläche des Mittelbalkens 8 (Fig.2), um die beiden auf gleichem Potential befindlichen Platten 9 und 10 elektrisch durch plattenförmige Leiter (nicht gezeichnet) ohne Kontakt mit dem Mittelbalken 8 über diesen hinweg verbinden zu können.

Der gesamte sandwichartige Aufbau gestattet am Mittelbalken 8 und an den Platten 9 und 10 Anschlüsse elektrischer Verbraucher, wie z.B. von Schweissmaschinen. Die hierfür notwendigen Bohrungen (nicht gezeichnet) zum Anschliessen der Kontaktschienen zum Verbraucher sind bereits auf den dem Transformator 4 abgewandten Seiten des Mittelbalkens 8 und der Platten 9 und 10 vorhanden (ausserhalb des Bereiches der Kühlwasserbohrungen und der Hohlräume).

Die Kühlmittelleitung zu den Dioden 111 - 138 wird im folgenden anhand der Fig.4 am Beispiel der Kühlmittelleitungen zur Diode 111 und 112 erläutert. Die Kühlmittelleitung zu den übrigen Dioden erfolgt analog.

Am in Fig. 4 unteren und oberen Rand der inneren Elektrodenplatte 211 befinden sich je zwei in Richtung des sandwichartigen Baugruppenaufbaues verlaufende Bohrungen 60 und 61. Diese Bohrungen 60 und 61 sind über je eine mit ihnen fluchtende Bohrung 62 und 63 in Richtung des Mittelbalkens 8 durch die Platten 9 fortgesetzt und durch je eine Bohrung 64 und 65 im Mittelbalken 8 mit den entsprechenden Bohrungen 66 und 67 in der Platte 10 verbunden. Durch je eine Anfräsung 68 und 69 parallel zum Steg 19 ist die Bohrung 64 mit dem Hohlraum 12 und die Bohrung 65 mit dem Hohlraum 11 verbunden.

Die Bohrung 61 ist über eine radiale vom Rand der inneren Elektrodenplatte 211 her durch einen Deckel 25 führende weitere Bohrung 71 mit dem inneren Ende eines mit mehreren in einer Ebene liegenden, z. B. spiralförmigen Windungen, durch eine Nut gebildeten Kühlkanals 72 und die Bohrung 60 ist durch eine Bohrung 70 mit dem äusseren Ende desselben Kühlkanals 72 verbunden. Der Kühlkanal 72 ist mit dem Deckel 25 abgedeckt, der mit der inneren Elektrodenplatte 211 abschliesst, so dass ein kühlwasserdichtes System entsteht. Der vom Aussenrand der inneren Elektrodenplatte 211 bis zur Bohrwandung der Bohrung 60 führende Teil der Bohrung 70, und ebenso der entsprechende Teil der Bohrung 71 ist mit einem Stöpsel 73 verschlossen.

Die elastische Zwischenplatte 711 besitzt im Durchmesser gegenüber den Bohrungen 60 und 61 in der inneren Elektrodenplatte 211 erweiterte, in deren Achsrichtungen laufende Bohrungen 74 und 75.

Die Bohrung 74 bzw. 75 in der elastischen Zwischenplatte 711 setzt sich mit gleicher Achsrichtung in der äusseren Elektrodenplatte 311 fort und endet dort in einem Sackloch 76 bzw 77.

Vom Sackloch 77 in der Elektrodenplatte 311 führt eine Bohrung 79 radial vom Rand der Elektrodenplatte 311 durch diese und einen Deckel 26 zum inneren Ende eines z.B. spiralförmigen, durch eine Nut gebildeten Kühlkanals 80 analog dem Kühlkanal 71 in der Elektrodenplatte 211 und dem Deckel 25.

An den an der dem Mittelbalken 8 abgewandten Oberfläche endenden Ausgängen der Bohrungen 62, 63, 66, 67 sind Einstiche zur Aufnahme von Dichtungsringen 57 vorgesehen, welche die Bohrungsübergänge zuverlässig abdichten.

Ausgehend vom Anschluss 17 des Kühlmittelzuflusses von einem nicht gezeigten Wärmetauscher oder Kaltwasseranschluss wird das zufliessende Wasser vom Hohlraum 11 mittels paralleler Kühlkreisläufe an die einzelnen zu kühlenden Dioden verteilt und über den Hohlraum 12 und dessen Abfluss 18 wieder zum Wärmetauscher zurückgeführt oder an eine Abwasserleitung abgegeben. Der Kühlmittelfluss zu den einzelnen Dioden wird wieder am Beispiel der beiden symmetrisch zum Mittelbalken 8 angeordneten Dioden 111 und 115 beschrieben. Vom Hohlraum 11 fliesst das Kühlwasser in die Anfräsung 69 und verzweigt sich dort in der Bohrung 65 nach rechts und links zu den Dioden 111 und 115. Der rechte Pfad führt über die Bohrungen 63, 61 und verzweigt sich in der inneren Elektrodenplatte 211 über die Bohrung 71 in Richtung des Kühlkanals 72, kühlt auf seinem z.B. spiralförmigen Weg durch diesen die Kathode der Diode 111 und fliesst dann über die Bohrungen 70, 60, 62, 64 und die Anfräsung 68 wieder über den Hohlraum 12 zum Abfluss 18. Der andere Kühlwasserpfad der Verzweigung in der inneren Elektrodenplatte 211 führt weiter über die Bohrung 61 zur Bohrung 75, dem Sackloch 77 und die Bohrung 79 zum Kühlwasserkanal 80, kühlt hier die Anode der Diode 111 und fliesst wieder über die Bohrung 78, das Sackloch 76, das Bohrloch 74, vereinigt sich in der Bohrung 60 mit dem Kühlwasser der Kathode, und fiesst dann auf dem oben beschrieben Weg zum Abfluss 18. Der linke Pfad führt von der Anfräsung 69 über die Bohrungen 65, 67, zur Verzweigung in der inneren Elektrodenplatte 215, wobei Kathode und Anode der Diode 115 wie oben beschrieben gekühlt werden und das Kühlwasser durch die Bohrungen 66, 64 und die Anfräsung 68 zum Hohlraum 12 zurückfliesst.

Statt der Dioden 111 bis 138 können auch andere zu kühlende elektrische Elemente, z.B. Widerstände bei entsprechend angepassten Elektrodenplatten 211 bis 238 und 311 bis 338 eingebaut werden.

Statt der je vier Halbleiterdioden 111 bis 138 pro Phasenhalbwelle können auch nur je eine bis je drei Halbleiterdioden verwendet werden. Auch andere zu kühlende elektrische Elemente, z.B. Widerstände bei entsprechend angepassten Elektrodenplatten 211 bis 238 und 311 bis 338 können statt der Dioden 111 bis 138 eingebaut werden.

Der Dreiphasenhochstromtransformator 4 kann auch durch drei Einphasenhochstromtransformatoren ersetzt werden, deren Sekundärwicklungen endseitig an die Kupferbalken 101/102, 201/202, sowie 301/302 und mit je einer Mittelanzapfung an den Mittelanzapfungsbalken 13 angeschlossen sind. Statt der drei Einphasenhochstromtransformatoren mit sekundärseitiger Mittelanzapfund können auch Gleichrichterschaltungen in Brückenschaltung verwendet werden, wobei dann der Mittelbalken 8 entfällt und einer oder beide Platten der Gleichstromleiter die Hohlräume 11, 12 oder je einen der Hohlräume 11 bzw 12 für zu- und rückfliessendes Kühlwasser aufnehmen. Auch sind Schaltungsanordnungen mit weniger als drei Phasen möglich.

Als Material für die Baugruppen, in denen Kühlwasser geleitet wird, ist Elektrolytkupfer bevorzugt. Es hat sich gezeigt, dass Elektrolytkupfer im Gegensatz z.B. zu Aluminium bei Verwendung von Leitungswasser als Kühlmittel nicht oder nur geringfügig korrodiert.

Ueberraschenderweise wurde festgestellt, dass normales (elektrisch leitendes) Leitungswasser als Kühlmittel verwendet werden kann. Dem liegt die Erkenntnis zugrunde, dass die Potentialunterschiede zwischen den einzelnen, durch Isolationsmaterial 51, 52, 711, 712, ... elektrisch isolierten, aber vom gleichen Kühlmittelfluss durchflossenen Baugruppen gering sind. Elektrochemische Materialerosion wird zuverlässig bei der Verwendung von Kupfer und Kupferlegierungen für alle mit der Kühlflüssigkeit in Berührung stehende Leiter vermieden, würde aber z.B. bei Aluminium eintreten. Anstelle von normalem Leitungswasser können selbstverständlich auch schlechtleitende oder isolierende Kühlflüssigkeiten, wie deionisiertes Wasser oder Oel verwendet werden.

Die Kühlwasserzu- und -rückflussanschlüsse 17 und 18 sind an der unteren Stirnseite des Mittelbalkens 8 angebracht, könnten aber ohne Beeinträchtigung der Wirkungsweise der Anordnung auch in der oberen Stirnseite des Mittelbalkens 8 vorgesehen sein.

Bei aus Elektrolytkupfer, also einem weichen Material, bestehenden Platten 9, 10, 211 und 215, ... können die Dichtungsringe 57 entfallen und stattdessen die Oberflächen der Platten 9 und 10 und/oder die Oberflächen der angrenzenden Platten 211 und 215, ... durch Rillen aufgeraut werden, so dass sie sich beim späteren Zusammendrücken durch Anziehen der Schrauben 20 zwischen den Andruckplatten 411, 412, ... und dem Mittelbalken 8, abdichtend verformen.

**Patentansprüche**

1. Schaltungsanordnung mit mehreren zu kühlenden elektrischen Elementen (111-138), die mit elektrischen Anschlussleitern (9, 211, 311, 212, 312, ...) zusammengebaut sind, von denen wenigstens ein Teil Kühlkanäle (60-63, 66, 67, 70-72, 76-80) aufweist, durch die ein Kühlmittel fliesst, das die von den Elementen erzeugte und auf ihre Anschlussleiter übertragene Verlustwärme abführt, dadurch gekennzeichnet, dass die Elemente (111-138) mit ihren Anschlussleitern (9, 211, 311, 212, 312, ...) in einer oder mehreren Reihen entlang einem gemeinsamen Kühlmittelverteiler (8) angeordnet und sandwichartig mit diesem zusammengebaut sind, der Kühlmittelverteiler (8) einen Zufluss- und einen Rückflusshohlraum (11, 12) aufweist, an welche die Kühlkanäle (60-63, 66, 67, 70-72, 76-80) der Anschlussleiter (9, 211, 311, 212, 312, ...) der Elemente (111-138) parallel angeschlossen sind, und dass die Kühlkanäle (60-63, 66, 67, 70-72, 76-80) durch den sandwichartigen Zusammenbau mit dem Kühlmittelverteiler (8) unmittelbar ohne Fittings mit dem Zufluss- und Rückflusshohlraum (11, 12) kommunizieren und die aneinander angrenzenden, Kühlmittel leitenden elektrischen Leiter (8, 9, 10, 211, 311, 212, 312, ...), die auf unterschiedlichem elektrischen Potential liegen, unter Freihaltung des Kühlmitteldurchgangs dicht und elektrisch voneinander isoliert miteinander verbunden sind.

2. Schaltungsanordnung nach Anspruch 1, dadurch gekennzeichnet, dass der Kühlmittelverteiler (8) ein elektrischer Leiter der Anordnung ist.

3. Schaltungsanordnung nach Anspruch 1 oder 2, dadurch gekennzeichnet, dass jedes der zu kühlenden elektrischen Elemente (111-138) zwischen zwei als plattenförmige, mit Kühlkanälen (60, 61, 70-72, 76-80) versehene Elektrodenplatten (211, 311, 212, 312, ...) ausgebildeten Anschlussleitern angeordnet ist.

4. Schaltungsanordnung nach einem der Ansprüche 1 bis 3, dadurch gekennzeichnet, dass die aneinander angrenzenden, Kühlmittel leitenden elektrischen Leiter (8, 9, 10, 211, 311, 212, 312, ...), die auf unterschiedlichem elektrischen Potential liegen, durch Dichtungsfolien oder -platten (51, 52, 711, 712, ...) mit Durchgangslöchern (74, 75) für das Kühlmittel elektrisch voneinander isoliert sind.

5. Schaltungsanordnung nach einem der Ansprüche 1 bis 4, dadurch gekennzeichnet, dass der Kühlmittelverteiler (8) als Balken ausgebildet ist, der Zufluss- und Rückflusshohlraum (11, 12) an gegenüberliegenden Seiten des Balkens (8) liegen und die zu kühlenden Elemente (111-138) mit ihren Anschlussleitern (9, 211, 311, 212, 312, ...) reihenweise beidseits des Balkens an den den Zufluss- und Rückflusshohlraum (11, 12) aufweisenden Balkenseiten (8) angeordnet sind.

6. Schaltungsanordnung nach einem der Ansprüche 1 bis 4, mit einem Mehrphasentransformator (4) oder einem Transformator (4) für mehrere Einzelphasen und mit zu kühlenden Gleichrichterelementen (111-138), dadurch gekennzeichnet, dass der Kühlmittelverteiler (8) als Balken ausgebildet ist, der Zufluss- und Rückflusshohlraum (11, 12) an gegenüberliegenden Seiten des Balkens (8) liegen, die zu kühlenden Gleichrichterelemente (111-138) mit ihren Anschlussleitern (9, 211, 311, 212, 312, ...) reihenweise beidseits des Balkens an den den Zufluss- und Rückflusshohlraum (11, 12) aufweisenden Balkenseiten (8) angeordnet sind, und der Kühlmittelverteiler (8) mit einer seiner anderen Seitenflächen an einer Mittelanzapfung (13) des Mehrphasentransformators (4) bzw. Transformators (4) für mehrere Einzelphasen leitend anliegt.

7. Schaltungsanordnung nach Anspruch 6, dadurch gekennzeichnet, dass die Leiter (9, 10, 211, 212, ...) mit gleichgerichteter Spannung nur durch je eine elektrisch isolierende, mit Durchgangslöchern für das Kühlmittel versehene Dichtungsfolie (51, 52) vom balkenförmigen Kühlmittelverteiler (8) getrennt beidseits an diesem gehalten sind.

8. Schaltungsanordnung nach einem der Ansprüche 1 bis 7, mit zu kühlenden Halbleiterdioden (111-138), dadurch gekennzeichnet, dass jede der zu kühlenden Halbleiterdioden (111-138) zwischen zwei als plattenförmige Elektrodenplatten (211, 311, 212, 312, ...) ausgebildeten Anschlussleitern (211, 311, 212, 312, ...) eingespannt ist, deren jeder einen Kühlkanal (72, 80) mit mehreren in einer zur Sperrschicht der Diode parallelen Ebene liegenden Windungen aufweist, wobei das eine Ende des Kühlkanals (72, 80) mit dem Zuflusshohlraum (11) und das andere Ende mit dem Rückflusshohlraum (12) des Kühlmittelverteilers (8) kommuniziert.

9. Schaltungsanordnung nach einem der Ansprüche 1 bis 8, dadurch gekennzeichnet, dass der Kühlmittelverteiler (8) und sämtliche der Kühlkanäle (60-63, 66, 67, 70-72, 76-80) aufweisenden Leiter (9, 10, 211, 311, 212, 312, ...) aus einem oberflächlich unter Druck verformbaren, leitenden Material, insbesondere Elyktrolytkupfer, gebildet sind.

10. Schaltungsanordnung nach einem der Ansprüche 1 bis 9, dadurch gekennzeichnet, dass alle mit der Kühlflüssigkeit in Berührung stehenden Leiter aus Kupfer oder einer Kupferlegierung bestehen.

## Claims

1. A circuit arrangement with a plurality of electrical elements (111-138) which are to be cooled and which are assembled together with electrical connecting conductors (9, 211, 311, 212, 312, ...), of which at least some have cooling passages (60-63, 66, 67, 70-72, 76-80) through which flows a coolant which dissipates lost heat generated by the elements and transmitted to their connecting conductors, characterised in that together with their connecting conductors (9, 211, 311, 212, 312, ...), the elements (111-138) are disposed in one or more rows along a common coolant distributor (8) being assembled sandwich-like together therewith, the coolant distributor (8) comprising a feed and return cavity (11, 12) to which the cooling passages (60-63, 66, 67, 70-72, 76-80) of the connecting conductors (9, 211, 311, 212, 312, ...) of the elements (111-138) are connected in parallel and in that the cooling passages (60-63, 66, 67, 70-72, 76-80) directly and without fittings communicate with the feed and return cavity (11, 12) by reason of the sandwich-like assembly together with the coolant distributor (8), the mutually adjacent coolant conducting electrical conductors (8, 9, 10, 211, 311, 212, 312, ...), which are at different electrical potential, are connected to one another in a sealing-tight and electrically insulated fashion while the coolant passage is kept clear.

2. A circuit arrangement according to Claim 1, characterised in that the coolant distributor (8) is an electrical conductor in the arrangement.

3. A circuit arrangement according to Claim 1 or 2, characterised in that each of the electrical elements (111-138) to be cooled is disposed between two connecting conductors constructed as plate-like electrode plates (211, 311, 212, 312, ...) which are provided with cooling passages (60, 61, 70-72, 76-80).

4. A circuit arrangement according to one of Claims 1 to 3, characterised in that the mutually adjacent coolant-carrying electrical conductors (8, 9, 10, 211, 311, 212, 312 ...) which are at a different electrical potential are electrically insulated from one another by sealing foils or plates (51, 52, 711, 712, ...) with apertures (74, 75) through which the coolant can pass.

5. A circuit arrangement according to one of Claims 1 to 4, characterised in that the coolant distributor (8) is constructed as a bar, the feed and return cavity (11, 12) being disposed on opposite sides of the bar (8), the elements (111-138) which are to be cooled being disposed together with their connecting conductors (9, 211 , 311, 212, 312, ...) in rows on either sides of the bar on the sides (8) of the bar which comprise the feed and return cavity (11, 12).

6. A circuit arrangement according to one of Claims 1 to 4, with a multiphase transformer (4) or a transformer (4) for a plurality of individual phases and with rectifier elements (111-138) which are to be cooled, characterised in that the coolant distributor (8) is constructed as a bar and in that the feed and return cavity (11, 12) are disposed on opposite sides of the bar (8), the rectifier elements (111-138) which are to be cooled are disposed together with their connecting conductors (9, 211, 311, 212, 312, ...) in rows on both sides of the bar on the sides (8) of the bar which comprise the feed and return cavity (11, 12), and in that the coolant distributor (8) has one of its other lateral faces bearing in conductive fashion on a middle tapping (13) of the multiphase transformer (4) or transformer (4) for a plurality of individual phases.

7. A circuit arrangement according to Claim 6, characterised in that the conductors (9, 10, 211, 212, ...) with a rectified voltage are held only by a respective electrically insulating sealing foil (51, 52) which is provided with holes through which the coolant can pass on both sides of but separated from the rod-like coolant distributor (8).

8. A circuit arrangement according to one of Claims 1 to 7, characterised in that semi-conductor diodes (111-138) which have to be cooled, characterised in that each of the semi-conductor diodes (111-138) which have to be cooled is clamped between two connecting conductors (211, 311 , 212, 312, ...) constructed as plate-like electrode plates (211, 311, 212, 312) and each of which has a cooling passage (72, 80) with a plurality of windings disposed in a plane parallel with the barrier coating on the diode, one end of the cooling passage (72, 80) communicating with the supply cavity (11) while the other end communicates with the return cavity (12) of the coolant distributor (8).

9. A circuit arrangement according to one of Claims 1 to 8, characterised in that the coolant distributor (8) and all the conductors (9, 10, 211, 311, 212, 312, ...) which have cooling passages (60-63, 66, 67, 70-72, 76-80) consist of a superficially pressure deformable conductive material, particularly electrolytic copper.

10. A circuit arrangement according to one of Claims 1 to 9, characterised in that all the conductors which are in contact with the cooling liquid consist of copper or a copper alloy.

**Revendications**

1. Agencement de circuit comportant plusieurs éléments électriques (111-138) devant être refroidis, qui sont regroupés avec des conducteurs électriques de raccordement (9, 211, 311, 212, 312, ...) dont au moins une partie présente des canaux de refroidissement (60-63, 66, 67, 70-72, 76-80) par lesquels circule un fluide de refroidissement qui dissipe la chaleur perdue engendrée par les éléments, et transférée à leurs conducteurs de raccordement, caractérisé par le fait que les éléments (111-138) sont agencés, avec leurs conducteurs de raccordement (9, 211, 311, 212, 312, ...), en une ou plusieurs rangées le long d'un répartiteur commun (8) de fluide de refroidissement, avec lequel ils sont regroupés en sandwich ; par le fait que le répartiteur (8) de fluide de refroidissement comporte une cavité d'afflux et une cavité de reflux (11, 12), auxquelles les canaux de refroidissement (60-63, 66, 67, 70-72, 76-80) des conducteurs de raccordement (9, 211, 311, 212, 312, ...) des éléments (111-138) sont raccordés en parallèle ; et par le fait que, suite au regroupement du type sandwich avec le répartiteur (8) de fluide de refroidissement, les canaux de refroidissement (60-63, 66, 67, 70-72, 76-80) communiquent directement avec les cavités d'afflux et de reflux (11, 12), sans organes de jonction, et les conducteurs électriques (8, 9, 10, 211, 311, 212, 312, ...) mutuellement adjacents, qui conduisent du fluide de refroidissement et auxquels est appliqué un potentiel électrique différent, sont mutuellement reliés en étant isolés hermétiquement et électriquement les uns des autres, en autorisant la circulation du fluide de refroidissement.

2. Agencement de circuit selon la revendication 1, caractérisé par le fait que le répartiteur (8) de fluide de refroidissement est un conducteur électrique dudit agencement.

3. Agencement de circuit selon la revendication 1 ou 2, caractérisé par le fait que chacun des éléments électriques (111-138) devant être refroidis est interposé entre deux conducteurs de raccordement qui sont réalisés sous la forme de platines-électrodes (211, 311, 212, 312, ...) de configuration aplatie, pourvues de canaux de refroidissement (60, 61, 70-72, 76-80).

4. Agencement de circuit selon l'une des revendications 1 à 3, caractérisé par le fait que les conducteurs électriques (8, 9, 10, 211, 311, 212, 312, ...) mutuellement adjacents, qui conduisent du fluide de refroidissement et auxquels est appliqué un potentiel électrique différent, sont isolés électriquement les uns des autres par l'intermédiaire de feuilles ou plaquettes d'étanchement (51, 52, 711, 712, ...) qui sont percées de trous (74, 75) de passage du fluide de refroidissement.

5. Agencement de circuit selon l'une des revendications 1 à 4, caractérisé par le fait que le répartiteur (8) de fluide de refroidissement est réalisé sous la forme d'une barrette ; les cavités d'afflux et de reflux (11, 12) se trouvent sur des côtés opposés de la barrette (8) ; et les éléments (111-138) devant être refroidis sont agencés, avec leurs conducteurs de raccordement (9, 211, 311, 212, 312, ...), en des rangées de part et d'autre de la barrette, sur les côtés de cette barrette (8) qui présentent les cavités d'afflux et de reflux (11, 12).

6. Agencement de circuit selon l'une des revendications 1 à 4, comprenant un transformateur polyphasé (4) ou un transformateur (4) pour plusieurs phases individuelles, ainsi que des éléments redresseurs (111-138) devant être refroidis, caractérisé par le fait que le répartiteur (8) de fluide de refroidissement est réalisé sous la forme d'une barrette ; les cavités d'afflux et de reflux (11, 12) se trouvent sur des côtés opposés de la barrette (8) ; les éléments redresseurs (111-138) devant être refroidis sont agencés, avec leurs conducteurs de raccordement (9, 211, 311, 212, 312, ...), en des rangées de part et d'autre de la barrette, sur les côtés de cette barrette (8) qui présentent les cavités d'afflux et de reflux (11, 12) ; et le répartiteur (8) de fluide de refroidissement est en contact conducteur, par l'une de ses autres surfaces latérales, avec une prise centrale (13) du transformateur polyphasé (4), respectivement du transformateur (4) pour plusieurs phases individuelles.

7. Agencement de circuit selon la revendication 6, caractérisé par le fait que les conducteurs (9, 10, 211, 212, ...) à tension redressée sont retenus de part et d'autre sur le répartiteur (8) de fluide de refroidissement, configuré en une barrette, dont ils sont séparés uniquement par l'intermédiaire d'une feuille respective d'étanchement (51, 52) électriquement isolante, percée de trous de passage du fluide de refroidissement.

8. Agencement de circuit selon l'une des revendications 1 à 7, présentant des diodes semi-conductrices (111-138) devant être refroidies, caractérisé par le fait que chacune des diodes semi-conductrices (111-138) devant être refroidies est enchâssée entre deux conducteurs de raccordement (211, 311, 212, 312, ...) qui sont réalisés sous la forme de platines-électrodes (211, 311, 212, 312, ...) de configuration aplatie, et dont chacun comporte un canal de refroidissement (72, 80) comprenant plusieurs spires situées dans un plan parallèle à la couche diélectrique de la diode, l'une des extrémités du canal de refroidissement (72, 80) communiquant avec la cavité d'afflux (11), et l'autre extrémité communiquant avec la cavité de reflux (12) du répartiteur (8) de fluide de refroidissement.

9. Agencement de circuit selon l'une des revendications 1 à 8, caractérisé par le fait que le répartiteur (8) de fluide de refroidissement, et l'intégralité des conducteurs (9, 10, 211, 311, 212, 312, ...) munis de canaux de refroidissement (60-63, 66, 67, 70-72, 76-80), sont constitués d'un matériau conducteur, en particulier du cuivre électrolytique, dont la surface peut être déformée sous pression.

10. Agencement de circuit selon l'une des revendications 1 à 9, caractérisé par le fait que tous les conducteurs qui sont en contact avec le fluide de refroidissement consistent en du cuivre, ou en un alliage de cuivre.

Fig. 2

Fig. 3

Fig.1

Fig.4